# FASCICULE DE BREVET EUROPEEN

(11) **EP 0 493 214 B1**
(45) Date de publication et mention de la délivrance du brevet: **20.03.1996**
(21) Numéro de dépôt: 91403467.3
(22) Date de dépôt: 19.12.1991
(51) Int. Cl.: H05K 7/14, G06F 13/40

(54) **Structure d'accueil pour adaptateurs de terminaux appartenant à une architecture informatique distribuée**
Aufnahmestruktur für zu einem verteilten Computeraufbau gehörenden Terminaladapter
Shell structure for terminal adapter belonging to a distributed architecture of a computer system

(30) Priorité: 20.12.1990 FR 9016032
(43) Date de publication de la demande: 01.07.1992
(73) Titulaire: BULL S.A., F-92800 Puteaux (FR)
(72) Inventeur: Chotard, Antoine, F-78450 Villepreux (FR); Belloir, Jean-Jacques, F-38130 Echirolles (FR); Iceta, Thierry, F-38950 Saint Martin le Vinoux (FR)
(74) Mandataire: Gouesmel, Daniel

(56) Documents cités:
- EP-A- 0 262 685
- EP-A- 0 345 493

## Description

La présente invention concerne une structure d'accueil pour adaptateurs de terminaux appartenant à une architecture informatique distribuée. Elle est particulièrement applicable à une architecture utilisant un réseau local de type à méthode d'accès à test de porteuse et détection de collision, réseau désigné fréquemment sous son sigle anglo-saxon CSMA/CD. L'invention s'applique plus spécialement aux réseaux locaux de type ETHERNET ou CHEAPERNET. Ceux-ci seront désignés, dans la suite du texte, sous le nom global de réseaux ETHERNET.

Les réseaux de communications sont constitués par une pluralité d'unités, généralement appelées "équipement terminal de traitement de données", en abrégé, ETTD (Data Terminal Equipment, en langue anglaise, en abrégé, DTE). Elles sont encore appelées terminaux ou stations par commodité de langage. Un ordinateur relié à un réseau est considéré comme un terminal. Les terminaux communiquent entre eux par l'intermédiaire d'un support de transmission qui peut être par exemple un câble coaxial, dans le cas des réseaux ETHERNET.

Les réseaux locaux (local area network, en langue anglaise, en abrégé LAN) sont des réseaux limités à un emplacement géographique de surface restreinte, les distances entre les différentes stations étant de l'ordre de quelques mètres à dizaines de mètres, voire pouvant atteindre quelques kilomètres.

Les réseaux locaux de type CSMA/CD sont d'un usage fréquent dans la pratique courante. Ils sont normalisés par le Comité IEEE de l'Institute of Electrical and Electronic Engineers, sous la forme d'une norme dite 802.3 (reprise par l'I.S.O., Organisation Internationale de Normalisation, sous la forme de la norme ISO 8 802.3).

Les réseaux ETHERNET ont un débit de transmission des données de 10 Mbits/s, et leur support de transmission normalisé est un câble coaxial d'impédance caractéristique 50 Ohms.

On sait qu'un ordinateur est constitué d'une part, d'un ou de plusieurs processeurs centraux, de processeurs d'entrée/sortie, de mémoires vives et mémoires mortes associées à l'ensemble de ces processeurs, de contrôleurs d'entrée/sortie, d'autre part de différents organes périphériques tels que mémoires à disques ou périphériques d'entrée/sortie permettant l'échange de données avec l'extérieur (terminaux à écran, imprimantes, etc..), ces organes périphériques étant associés à des contrôleurs de périphériques (cf. par exemple EP-A-0 345 493).

L'ensemble des éléments constitutifs précités (en dehors des périphériques) est disposé sur un ensemble de cartes (boards en anglais) dont les dimensions sont normalisées.

La tendance du développement technologique des réseaux, l'utilisation de terminaux de plus en plus nombreux, conduisent à développer au sein même des ordinateurs, des serveurs de communication programmés, dont le rôle est de réduire la charge de l'unité centrale de l'ordinateur en effectuant une partie de la gestion, d'une part des messages émis par les différents éléments constitutifs de l'ordinateur vers le réseau de télécommunications auquel ce dernier est relié, et d'autre part des messages provenant des autres terminaux du réseau.

Le développement extrêmement rapide de la puissance et de la capacité de traitement des unités centrales des ordinateurs fait qu'il est possible de faire communiquer un nombre de plus en plus grand de périphériques d'entrée/sortie avec les processeurs centraux de l'ordinateur. Ces périphériques d'entrée/sortie sont des terminaux synchrones ou asynchrones communiquant avec leur environnement extérieur par l'intermédiaire de lignes de transmission ayant des débits pouvant aller de 300 bits/s à 64 kbits/s. Ces terminaux d'entrée/sortie d'un ordinateur communiquent avec l'extérieur par l'intermédiaire d'une grande diversité d'appareils dénommés Modem (contraction des deux mots modulateur-démodulateur) dont la fonction est d'adapter le signal électrique délivré par le terminal d'entrée/sortie au support de transmission qui relie le terminal à son environnement extérieur. Ces Modem sont par exemple définis par les avis V-24, V-28, V-11, V-35, V-36 du CCITT (Comité Consultatif International Télégraphique et Téléphonique). Ces différents avis définissent également les modes de transmission et les protocoles sur les liaisons de transmission correspondantes. Celles-ci sont supportées physiquement par des supports de transmission qui ont en fait autant de câbles ou ensembles de fils distincts.

Les grands systèmes informatiques modernes constitués donc par un ordinateur, son serveur de communication et les différents terminaux d'entrée/sortie qui lui sont connectés peuvent compter jusqu'à plusieurs centaines de terminaux qui sont donc reliés par autant de câbles ou ensembles de fils à l'ordinateur. Lorsque les terminaux sont répartis dans un site géographique de surface restreinte, l'existence d'un grand nombre de câbles et de fils pose des problèmes mécaniques, physiques (diaphonies, etc..) et d'encombrement trop importants.

Dans la pratique, il est commode de relier chaque système informatique, d'une part à d'autres systèmes, et d'autre part aux terminaux d'entrée/sortie par l'intermédiaire d'un réseau ETHERNET.

Le but de l'invention est de déporter tous les supports de transmission constitués par ces câbles ou ensemble de fils à l'extérieur de l'espace géographique occupé par l'ordinateur et son serveur de communication. Le serveur de communication est relié alors aux différents terminaux par l'intermédiaire d'une pluralité d'adaptateurs dont la fonction est d'adapter le débit de transmission et le protocole de transmission du réseau ETHERNET aux débits et aux protocoles utilisés sur les différentes lignes de transmission propres à chaque terminal d'entrée/sortie. Pour parvenir à ce but, on regroupe une pluralité d'adaptateurs dans un même espace géographique appelé structure d'accueil constitué, par exemple, par un panier contenant plusieurs de ceux-ci, par exemple une quinzaine, voire davantage.

L'ensemble des adaptateurs contenus dans une même structure d'accueil constitue un système adaptateur. On peut naturellement relier ensemble plusieurs systèmes adaptateurs de ce type, chaque système adaptateur étant relié à son voisin par un câble coaxial dont la longueur minimum est de 0,50 m, conformément à la norme ETHERNET.

Un même système adaptateur peut être considéré comme un terminal du réseau ETHERNET auquel il est relié.

Le fait de regrouper dans une même structure d'accueil une pluralité d'adaptateurs permet d'éviter de relier chaque adaptateur à son voisin par un câble coaxial de longueur minimum égale à 0,50 m selon la norme précitée. En effet, si les adaptateurs sont physiquement séparés les uns des autres, ils sont considérés comme des terminaux du réseau ETHERNET et de ce fait doivent être reliés entre eux par des câbles coaxiaux ayant ladite longueur maximum. Ainsi, l'invention permet de réduire sensiblement l'espace occupé par les adaptateurs et leurs supports de transmission, en réduisant le nombre de ces derniers.

Selon l'invention, la structure d'accueil pour adaptateurs de terminaux, appartenant à une architecture informatique distribuée, formée d'une pluralité de systèmes informatiques connectés chacun par l'intermédiaire de serveurs de communication à une pluralité de réseaux de divers types, chaque système étant relié à une pluralité de terminaux synchrones ou asynchrones par l'intermédiaire d'au moins l'un des réseaux et d'adaptateurs de terminaux dont chacun est, d'une part connecté audit réseau et d'autre part à au moins un terminal par l'intermédiaire d'une liaison de transmission synchrone ou asynchrone, est caractérisée en ce qu'elle comprend :
- un premier compartiment contenant une pluralité de cartouches comportant chacune une carte portant le circuit électronique d'un adaptateur,
- un second compartiment contenant l'alimentation électrique des cartes des adaptateurs contenus dans le premier compartiment et un dispositif de ventilation de la structure,
le premier et le second compartiments étant adjacents et séparés l'un de l'autre par un fond de panier portant un bus spécifique du réseau auquel sont connectés les adaptateurs, le fond de panier comportant des moyens de connexion du bus aux cartes et au réseau d'une part, et à l'alimentation d'autre part.

D'autres caractéristiques et avantages de la présente invention apparaîtront dans la description suivante donnée à titre d'exemple non limitatif et en se référant aux dessins annexés.

Sur ces dessins :
- la Figure 1 est un schéma très simplifié de l'architecture informatique distribuée à laquelle appartiennent les adaptateurs de terminaux regroupés dans la structure d'accueil selon l'invention,
- la Figure 2 est un schéma très simplifié d'un système informatique comportant un ordinateur et un serveur de communication et un système adaptateur comprenant une pluralité d'adaptateurs reliés chacun à une pluralité de terminaux d'entrée/sortie, ces adaptateurs étant regroupés dans une structure d'accueil selon l'invention,
- la Figure 3 montre la structure matérielle d'un adaptateur de terminaux appartenant au système adaptateur contenu dans la structure d'accueil selon l'invention,
- les Figures 4 et 5 sont des vues de 3/4 en perspective, respectivement vue de l'arrière et vue de l'avant d'une cartouche contenant le circuit électronique d'un adaptateur, cette cartouche étant destinée à être insérée dans le premier compartiment (compartiment avant) de la structure d'accueil selon l'invention,
- la Figure 6 est une vue de dessus de ladite cartouche montrant le couvercle de celle-ci avec ses différents orifices permettant d'assurer la ventilation de la carte portant le circuit électronique formant l'adaptateur,
- La Figure 7, composée des figures 7a et 7b, montre, vues de l'avant, 2 cartouches de types différents, pouvant être contenues dans la structure d'accueil selon l'invention,
- La Figure 8 est une vue avant, de 3/4 en perspective, de la structure d'accueil selon l'invention,
- Les Figures 9 et 10 sont les vues, respectivement avant et arrière de 3/4 en perspective, plus détaillées de la Figure 8 de la structure d'accueil selon l'invention,
- La Figure 11, formée de l'ensemble de trois figures 11a, 11b, 11c, dont 11a et 11b sont des vues de dessus et 11c une vue en coupe transversale, montre le fond de panier séparant le premier et le second compartiment de la structure d'accueil selon l'invention, ce fond de panier portant un bus en cuivre de type ETHERNET et les différents connecteurs reliant ce bus aux différents adaptateurs contenus dans la structure d'accueil selon l'invention,
- Les Figures 12 et 13 illustrent l'avantage de la structure d'accueil selon l'invention, par rapport à l'art antérieur..

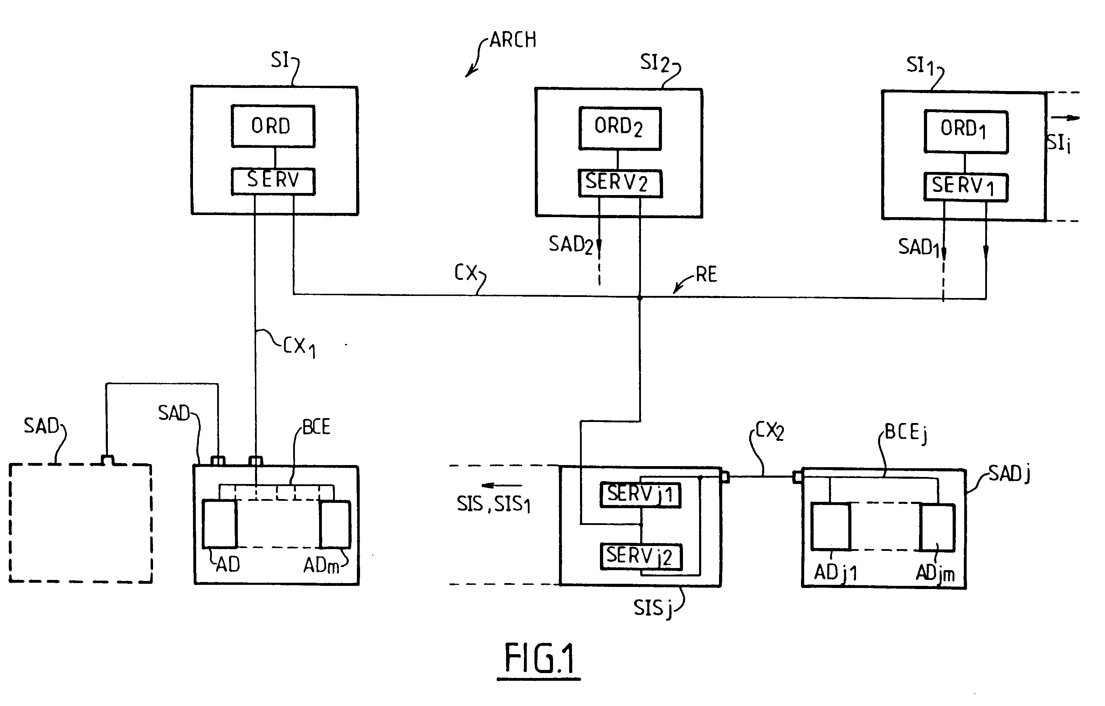

On considère la Figure 1 qui montre une architecture informatique distribuée ARCH dans laquelle s'insère la structure d'accueil selon l'invention. ARCH comprend d'une part une pluralité de systèmes informatiques SI, SI₁, SI₂,...., SIᵢ, une pluralité de systèmes informatiques serveurs SIS, SIS₁, .... SISⱼ, faisant tous partie d'un réseau ETHERNET RE, dont le support de transmission est constitué par un câble coaxial CX.

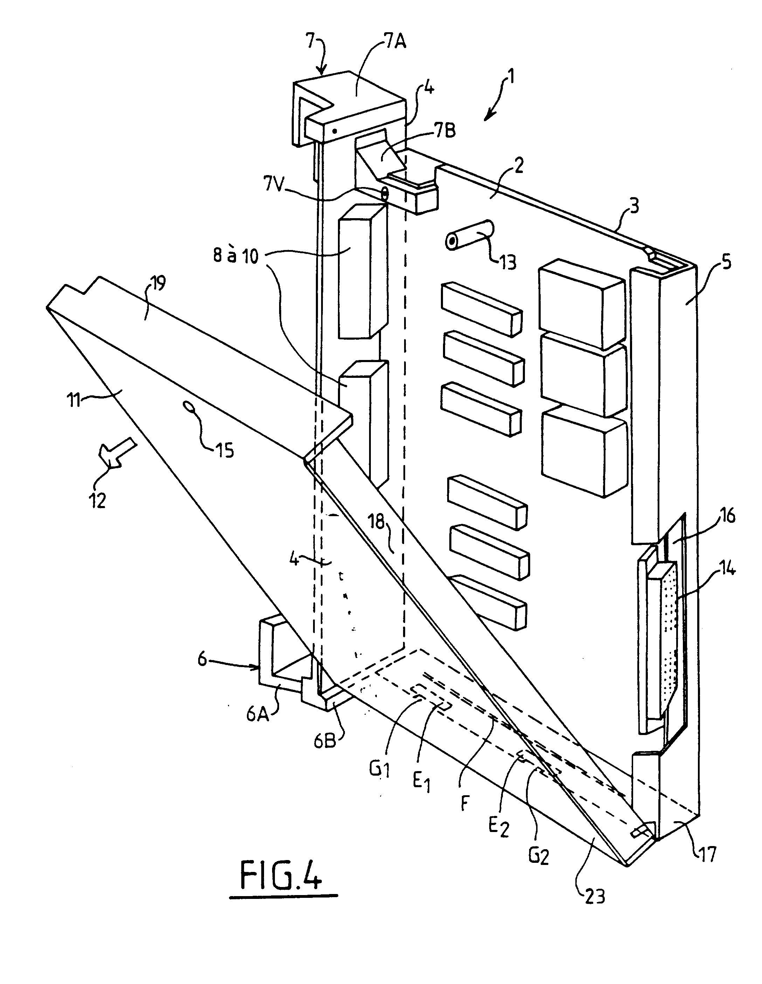

ARCH comprend en outre une pluralité de systèmes adaptateurs, tels que le système SAD relié par l'intermédiaire du câble coaxial CX₁ au système informatique SI ou encore le système adaptateur SADⱼ relié par l'intermédiaire du câble coaxial CX₂ au système informatique serveur SISⱼ. Chaque système adaptateur est contenu dans une structure d'accueil selon l'invention décrite en relation avec les Figures 4 à 13.

De même, les systèmes informatiques SI₁, SI₂ peuvent être reliés respectivement aux systèmes adaptateurs SAD₁, SAD₂, le système SIᵢ au système adaptateur SADᵢ, etc...

Les systèmes informatiques SI, SI₁... SIᵢ ont une structure analogue. Ainsi le système SI comprend un ordinateur ORD et un serveur de communication SERV, le système informatique SIᵢ comprenant de la même façon un ordinateur ORDᵢ et un serveur de communication SERVᵢ.

Les systèmes informatiques serveurs SISⱼ ont tous des structures analogues et comprennent par exemple :
- un premier serveur de communication (SERVⱼ₁)
- un second serveur de communication (SERVⱼ₂).

Tous les serveurs de communication SERV... SERVᵢ.... SERVⱼ₁, SERVⱼ₂.... etc... ont la même structure.

De la même façon, les systèmes adaptateurs SAD,.... SADⱼ ont tous une structure analogue. Ainsi, par exemple, le système adaptateur SAD comprend une pluralité d'adaptateurs de terminaux (AD, AD₁.... ADₘ...) alors que le système adaptateur SADⱼ comprend les adaptateurs de terminaux (ADⱼ₁... ADⱼₘ...).

Chaque adaptateur AD, ...ADₘ, ADⱼ₁..., ADⱼₘ est associé à une pluralité de terminaux d'entrée/sortie synchrones ou asynchrones, 3 dans l'exemple de réalisation préféré de l'invention.

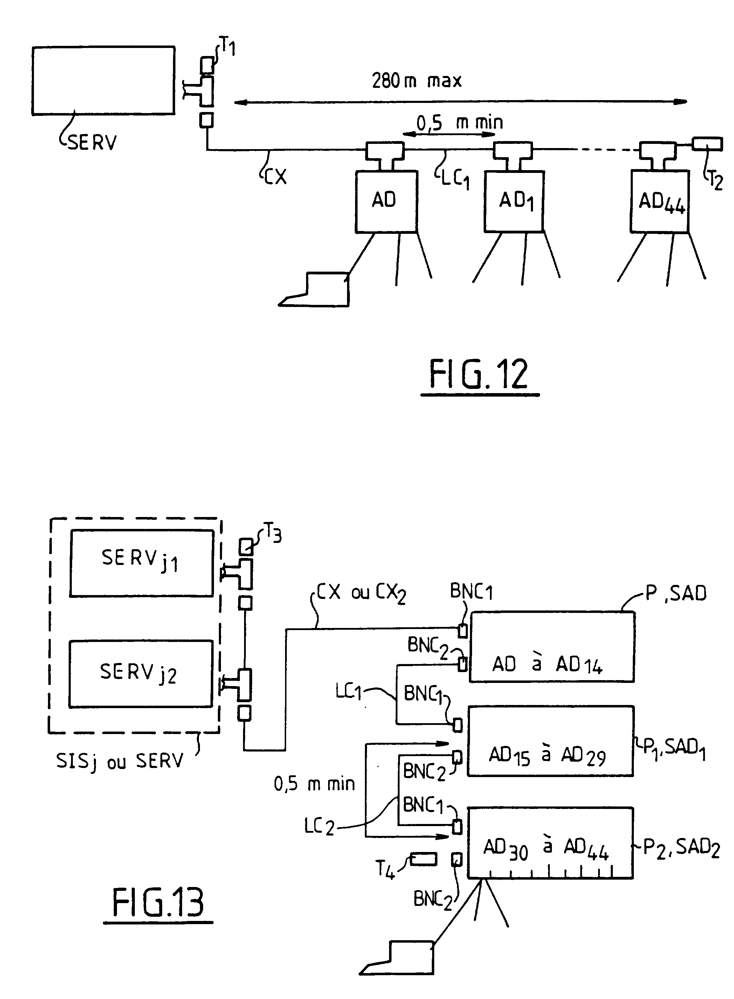

Le serveur SERV peut être, suivant les besoins, c'est-à-dire suivant le nombre de terminaux synchrones ou asynchrones qui lui sont reliés, associé à d'autres systèmes adaptateurs que SAD, par exemple notamment le système adaptateur SADₖ représenté à la Figure 1 (la manière détaillée dont SAD, SADₖ et SERV sont reliés entre eux est montrée à la Figure 13). Il est évident qu'il peut en être de même pour le système informatique serveur SISⱼ qui peut être connecté à d'autres systèmes adaptateurs que le système SADⱼ, suivant le nombre de terminaux d'entrée/sortie auxquels ce système informatique serveur est relié.

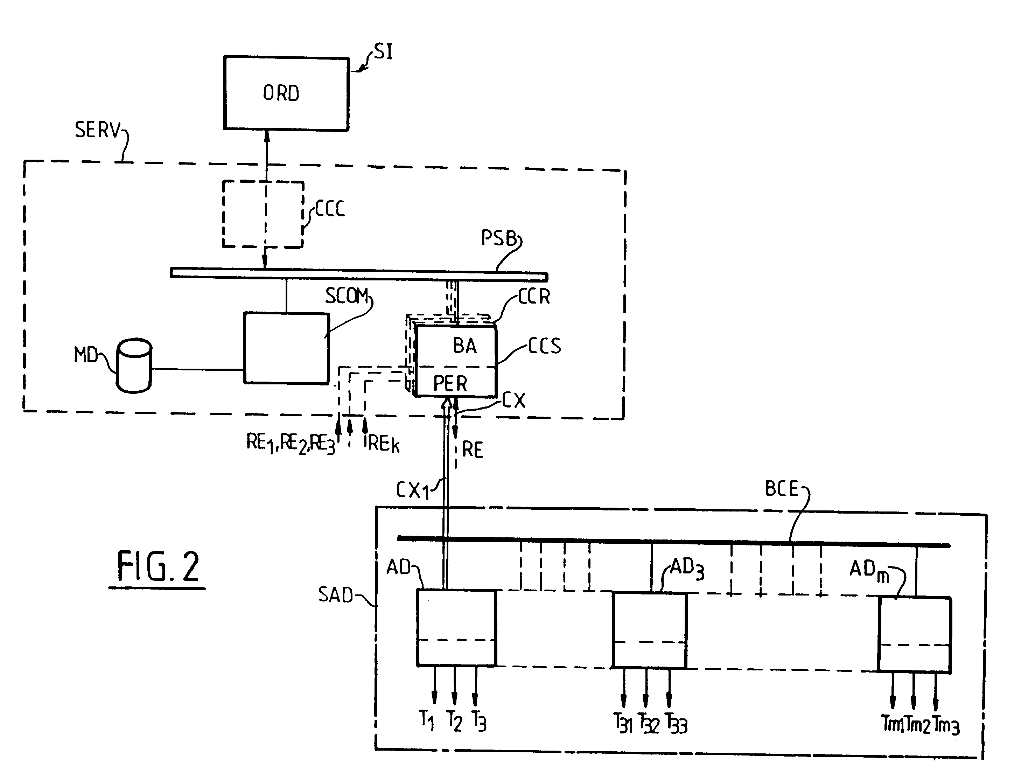

On se reporte à la Figure 2.

Cette dernière montre le système informatique SI qui comprend au moins un ordinateur ORD relié d'une part par l'intermédiaire du serveur SERV au réseau ETHERNET RE et au système adaptateur SAD et d'autre part par exemple à un ensemble de réseaux de type différent, (autres que de type ETHERNET) à savoir RE₁, RE₂, .... REₖ, par l'intermédiaire d'une pluralité de liaisons de type différent.

Le serveur SERV gère et effectue le transfert des trames expédiées par l'ordinateur ORD vers les réseaux et réciproquement. (On rappelle qu'un message émis par un terminal quelconque est formé d'un ensemble de blocs élémentaires d'informations binaires, chaque bloc étant appelé trame ou frame en langue anglaise)

Le serveur SERV comprend :
- une unité centrale SCOM qui administre et gère le serveur. Elle charge notamment tous les logiciels et micrologiciels associés à chacune des cartes constituant le serveur, dans celles-ci, lors de leur initialisation.
- le bus PSB de type parallèle, de préférence de type MULTIBUS II,
- un ensemble CCR de contrôleurs de communication permettant de relier le serveur (et par suite ORD) aux différents réseaux RE, RE₁,... REₖ. Il comprend plus particulièrement le contrôleur de communication CCS permettant de le relier, au réseau ETHERNET RE. Un tel contrôleur est décrit en détail dans la demande de brevet déposée ce jour, par la demanderesse, sous le titre "Architecture informatique distribuée utilisant un réseau local de type CSMA/CD".

Le serveur SERV, dans son ensemble, est ici considéré comme terminal du réseau RE, communiquant avec les autres terminaux SERV₁,.... SERVⱼ, ...., SISⱼ, .... SAD.

L'ordinateur ORD peut être relié soit directement au bus PSB, par exemple par l'intermédiaire d'un coprocesseur MPC 82389 (fabriqué par la Société INTEL), soit de préférence, par l'intermédiaire d'un coupleur central de communication (CCC), surtout dans le cas où plusieurs ordinateurs autres que ORD (non représentés pour simplifier à la Figure 2) sont reliés au serveur SERV (CCC est représenté en traits interrompus à la Figure 2). Dans ce cas, le coupleur CCC a une structure analogue à CCS.

Le système adaptateur SAD comprend, ainsi qu'il a été dit plus haut, des adaptateurs de terminaux AD, AD₁, AD₂, AD₃... ADₘ. L'adaptateur AD est associé aux terminaux d'entrée/sortie synchrones ou asynchrones T₁, T₂, T₃, alors que l'adaptateur ADm est associé aux terminaux d'entrée/sortie Tₘ₁, Tₘ₂ et Tₘ₃.

Chacun des adaptateurs du système SAD est connecté à un même bus cuivre BCE, de type ETHERNET faisant partie de la structure d'accueil selon l'invention et qui sera décrit plus en détail dans la suite du texte. On voit donc que, à son tour, le système SAD peut être considéré comme un terminal particulier du réseau ETHERNET RE.

Les trames provenant de l'ordinateur ORD destinées au réseau RE parviennent par l'intermédiaire de PSB au contrôleur de communication CCS. Ce dernier divise chacune de celles-ci en une pluralité de paquets de données ou "buffers" (terme anglo-saxon équivalent), forme à partir de ceux-ci une pluralité de trames de type ETHERNET, gère et effectue le transfert de celles-ci soit vers le système d'adaptateurs SAD, soit vers les autres terminaux du réseau RE. Réciproquement, il reçoit les trames ETHERNET provenant soit du système SAD, soit des autres terminaux de réseau RE, les divise en une pluralité de buffers et à partir de ceux-ci forme des trames destinées à l'ordinateur ORD. Il gère et effectue le transfert de celles-ci depuis le réseau RE vers l'ordinateur ORD.

Le rôle de chaque adaptateur est le suivant : il reçoit les trames ETHERNET provenant du serveur SERV par l'intermédiaire du câble CX₁, les stocke, et forme des trames dont le format est spécifique à chacun des terminaux d'entrée/sortie auquel il est associé. Il effectue ensuite le transfert de ces trames ainsi formées vers chacun de ces terminaux. On peut donc dire qu'il transforme les trames de type ETHERNET en trames spécifiques à chacun des terminaux d'entrée/sortie en effectuant l'adaptation du protocole et du débit de transmission propres au réseau ETHERNET au protocole et au débit de transmission propre aux liaisons spécifiques de ces mêmes terminaux. Le même travail est effectué dans l'autre sens, c'est-à-dire depuis les terminaux d'entrée/sortie vers le réseau ETHERNET.

La structure détaillée et le fonctionnement du contrôleur de communication CCS sont donnés dans la demande de brevet français précitée, déposée ce jour.

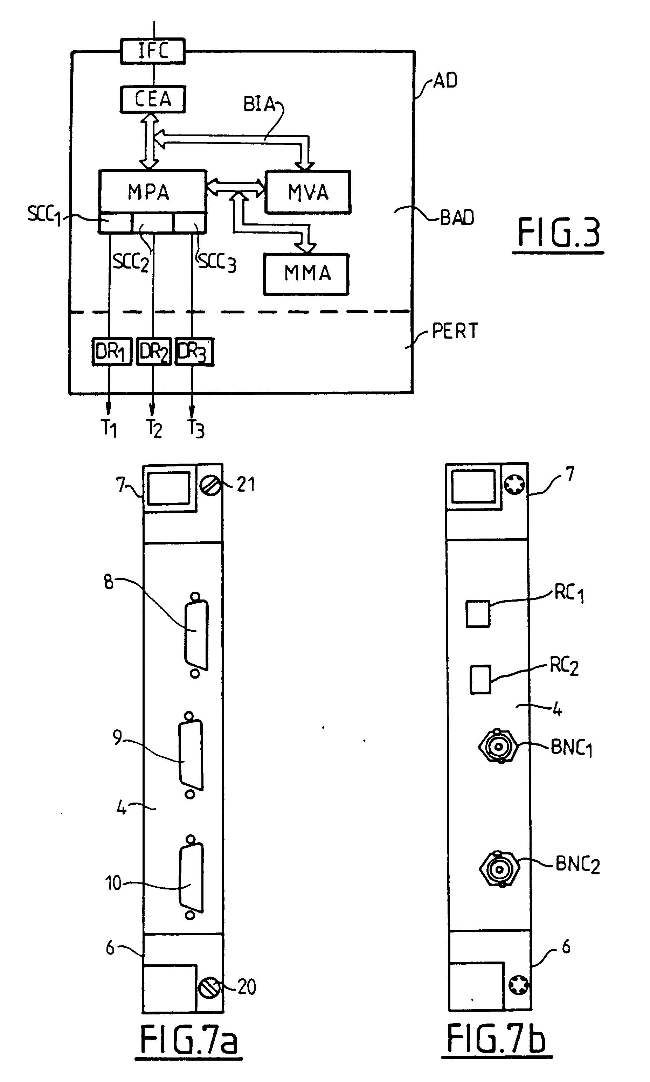

On considère désormais la Figure 3 qui montre la structure matérielle de l'adaptateur AD :

L'adaptateur AD comprend une unité de base BAD et une partie périphérique PERT.

L'unité de base BAD est strictement identique d'un adaptateur à l'autre, alors que la partie périphérique PERT diffère suivant le type de terminaux d'entrée/sortie auquel l'adaptateur est associé.

L'unité de base BAD comprend :
- une interface IFC constituée en fait par un transceiver de type CHEAPERNET, relié au câble CX₁ d'une manière qui sera précisée plus loin en liaison avec la description détaillée de la structure d'accueil.
- un contrôleur CEA de type ETHERNET, par exemple constitué par un circuit de la firme NATIONAL SEMI-CONDUCTORS appelé circuit SNIC ayant la référence 83901 chez ce constructeur. Un tel circuit permet d'émettre des trames respectant la norme 8802.3 précitée ou de recevoir des trames provenant du réseau RE conformes à cette dernière. Pour plus de détails concernant ce contrôleur CEA, on se reportera aux fiches techniques du constructeur.
- un microprocesseur MPA, associé d'une part à une mémoire vive MVA, de 512 Kilooctets de capacité et à une mémoire morte programmable MMA,
- les trois contrôleurs de communication série identique SCC₁, SCC₂, SCC₃ chacun de ceux-ci étant associé à un terminal particulier, le contrôleur SCC₁ étant associé au terminal T₁, le contrôleur SCC₂ au terminal T₂, le contrôleur SCC₃ au terminal T₃.

Dans une exemple préféré de réalisation de l'invention, le microprocesseur MPA et les 3 contrôleurs SCC₁ à SCC₃ sont constitués par un microcontrôleur 68302 de la Société MOTOROLA (on sait qu'un tel microcontrôleur est en fait formé par l'association d'un microprocesseur de type 68000 et d'une partie périphérique formée de contrôleurs de communication série. Le microprocesseur 68000 constitue donc le microprocesseur MPA alors que les 3 contrôleurs SCC₁ à SCC₃ constituent la partie périphérique du microcontrôleur 68302).

La partie périphérique PERT est constituée de 3 adaptateurs de ligne DR₁, DR₂, DR₃ correspondant respectivement chacun aux terminaux T₁, T₂, T₃ et aux contrôleurs de communication série SCC₁ à SCC₃.

Ainsi qu'on peut le voir à la Figure 4, les éléments CEA, MPA et MVA sont reliés au bus interne BIA du microprocesseur MPA, ce dernier étant par ailleurs relié aux mémoires MVA et MMA par un bus de même type que BIA.

Les adaptateurs de lignes DR₁, DR₂ et DR₃ sont par exemple constitués par des éléments 3487 - 3486 de la Société NATIONAL SEMICONDUCTORS. Rappelons que les adaptateurs de lignes ("line divers" en anglais) assurent l'adaptation électrique des niveaux de tension utilisés dans les circuits intégrés de type TTL (0 et 5 Volts) tels que ceux constituant l'adaptateur AD, au niveau utilisé sur les liaisons permettant de relier les adaptateurs aux terminaux T₁, T₂, T₃.

Il convient de préciser que chaque adaptateur tel que AD se voit attribuer par son constructeur une adresse ETHERNET sur 48 bits. Cette adresse est inscrite dans la mémoire MMA et est donc accessible par le microprocesseur MPA.

De même, chaque adaptateur, dès qu'il est inséré dans sa structure d'accueil, connaît, par l'intermédiaire du microprocesseur MPA, son emplacement géographique à l'intérieur de la structure et le numéro de celle-ci qui est attribué arbitrairement par le constructeur. Ceci constitue son adresse géographique qui est inscrite dans la structure par un dispositif de codage approprié (décrit plus loin) que vient lire le microprocesseur MPA dès l'insertion de l'adaptateur dans son panier.

De plus amples détails sur le fonctionnement de l'adaptateur AD ainsi que sur l'établissement du dialogue et le dialogue lui-même entre cet adaptateur et un serveur de communication tel que le serveur SERV sont fournis dans la demande de brevet français précitée déposée ce jour par la demanderesse.

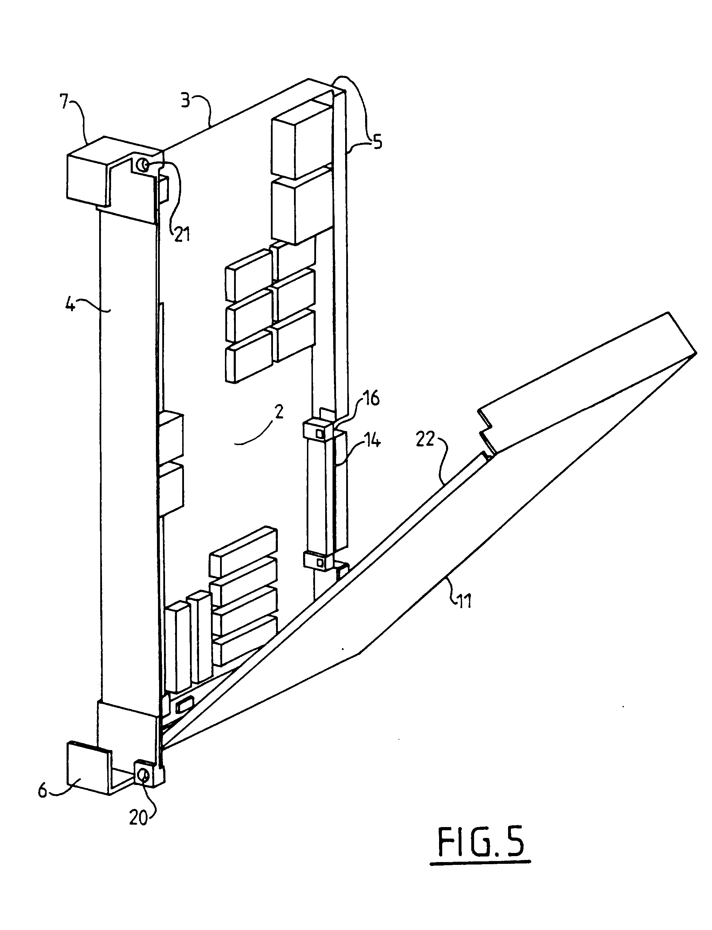

L'ensemble des éléments composant la structure matérielle de l'adaptateur AD montrée à la Figure 3 est disposé sur une carte telle que la carte 2 montrée aux Figures 4 et 5. On désigne donc dans ce texte sous le même nom d'adaptateur, aussi bien la carte que la structure matérielle formée des éléments décrits en relation avec la Figure 3, et que l'ensemble des moyens fonctionnels qui sont supportés par cette structure matérielle.

On considère désormais les Figures 4, 5, 6, 7a et 7b.

L'ensemble de ces Figures montre une cartouche 1 contenant une carte 2. Cette carte 2 peut être soit un adaptateur tel que celui décrit en relation avec les Figures 1 à 3, soit une carte spéciale portant un adaptateur d'interface dont le rôle sera explicité dans la suite du texte. Les cartouches telles que 1, ayant toutes la même structure quel que soit le type d'adaptateur, c'est-à-dire quel que soit le type de terminaux d'entrée/sortie auxquels est associé l'adaptateur correspondant, la description faite en relation avec les Figures 4 à 7 est valable pour tous les types d'adaptateurs. Pour la même raison, on désignera, sous les mêmes références, les éléments analogues de différentes cartouches, quel que soit le type d'adaptateur qu'elles contiennent.

La cartouche 1 comprend une enveloppe mécanique entourant la carte 2. Cette enveloppe mécanique est formée d'un support de base 3, d'un couvercle 11, d'une face avant 4, d'une face arrière 5 en forme de L obtenue par pliage de la même pièce métallique qui forme la base 3, la grande dimension du L étant perpendiculaire à cette dernière et parallèle à la face avant 4. La base 3 comporte également une embase rectangulaire 17 qui lui est perpendiculaire ainsi qu'aux faces avant et arrière 4 et 5. Cette embase 17 comporte une fente longitudinale F et deux encoches E₁ et E₂ parallèles à F.

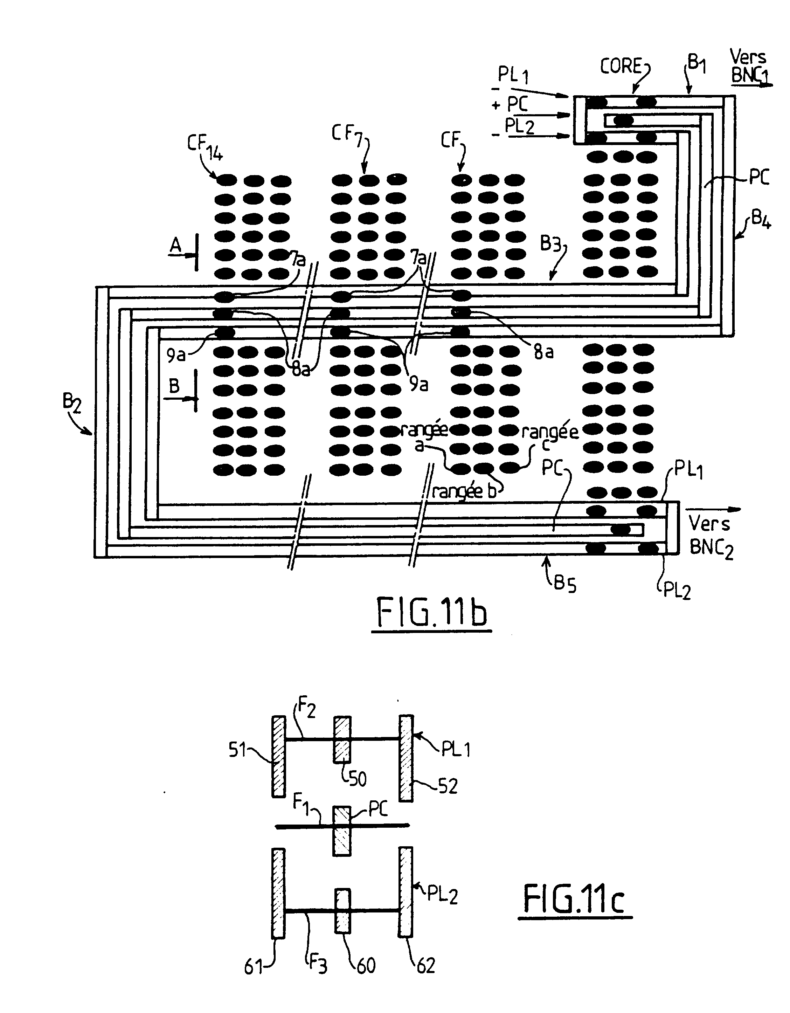

Le support de base 3 est une plaque rectangulaire ayant sensiblement les mêmes dimensions que la carte 2, laquelle comporte sur sa partie arrière un connecteur 14 permettant son raccordement au bus ETHERNET BCE (ou BCEⱼ) qui se trouve sur le fond de panier FP décrit dans la suite du texte en relation avec les Figures 11a, 11b, 11c. Le connecteur 14 est un connecteur standard DIN coudé femelle de type REVERSE 41612. La face arrière 5 comporte une échancrure 16 de forme rectangulaire permettant le passage du connecteur 14.

Aux Figures 4 et 5, on a représenté la carte 2 munie d'un certain nombre de ses composants qui sont symbolisés par des parallélépipèdes rectangles.

La face avant 4, est perpendiculaire au support de base 3 (pour des besoins de clarté de l'exposé et de meilleure compréhension des figures, la face avant 4 ne donne pas l'impression d'être perpendiculaire au support 3 à la Figure 4 ) .

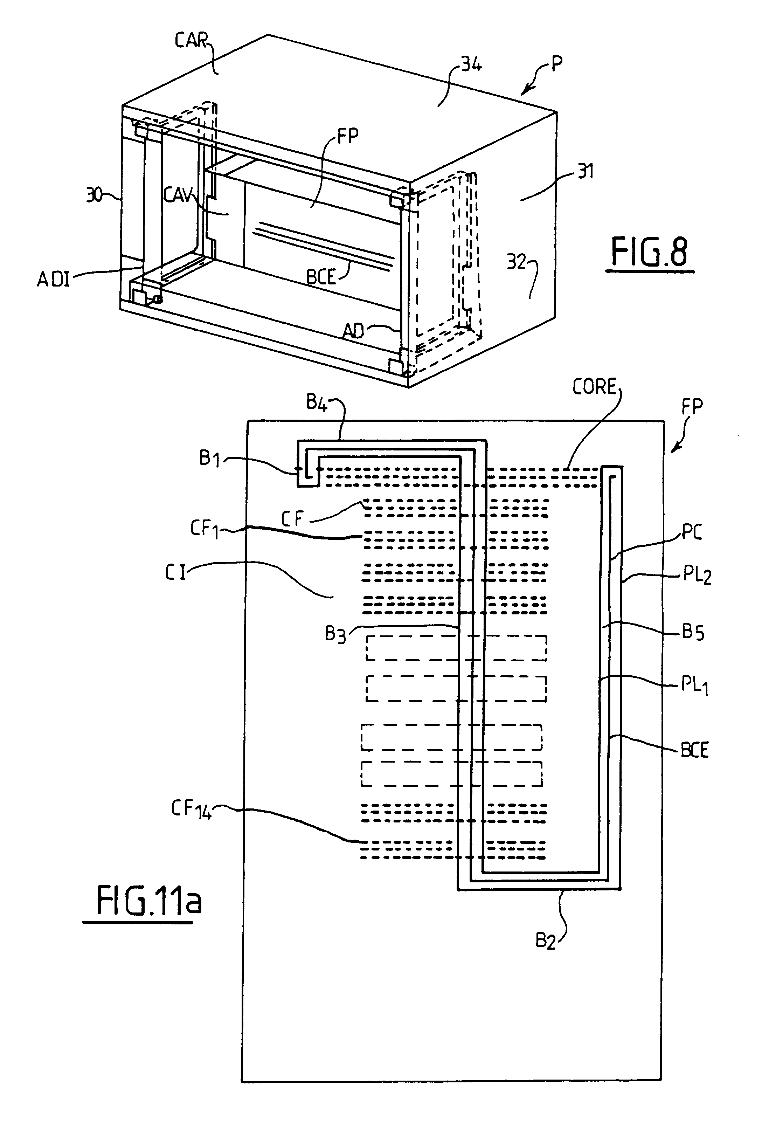

Cette face avant porte deux poignées de verrouillage 6 et 7 respectivement situées à chacune de ses extrémités, la poignée de verrouillage 6 étant située dans sa partie inférieure aux Figures 4 à 7, alors que la poignée de verrouillage 7 est située dans sa partie supérieure. Les deux poignées de verrouillage 6 et 7 permettent la préhension manuelle de la cartouche 1, en vue de son insertion dans la structure d'accueil P représentée aux Figures 8 à 10. Elles permettent également le verrouillage de la cartouche à l'intérieur de la structure d'accueil P.

La face avant 4 porte également 3 connecteurs 8 à 10 spécifiques de chaque liaison de transmission propre à chacun des terminaux d'entrée/sortie associés à l'adaptateur que porte la carte 2. Ces connecteurs sont disposés les uns au-dessus des autres et alignés verticalement. Ils sont vissés sur la carte 2 (au moyen de systèmes vis-écrou perpendiculaires à cette carte non représentés pour simplifier la Figure 4).

On notera également que les connecteurs 8 à 10 sont représentés à la Figure 4 détachés de la face avant 4 pour des besoins de compréhension évidents de la figure.

Les 3 connecteurs 8 à 10 sont des connecteurs standard de type Sub D. La Figure 7a permet de mieux apprécier, vu de face, l'emplacement de ces connecteurs 8 à 10 avec leur forme sensiblement trapézoïdale. Elle permet également de voir que les poignées 6 et 7 comportent des vis moletées 20 et 21 qui sont perpendiculaires à 5 et permettent le verrouillage de la cartouche dans la structure d'accueil, ainsi qu'on le verra mieux dans la suite de la description.

Les poignées 6 et 7 se composent en fait chacune d'une partie avant 6A, 7A disposée du côté opposé à la carte 2 par rapport à la face avant 4 et d'une protubérance arrière 6B, 7B. Les protubérances 6B et 7B comportent chacune un système vis-écrou 6V, 7V, perpendiculaire à la carte 2 et permettent ainsi la fixation des poignées 6 et 7 (et par suite de 4) sur cette dernière.

Ainsi, on peut voir que la carte 2 est rendue solidaire de la face avant 4 par les deux systèmes vis-écrou 6V - 7V et par les systèmes vis-écrou des connecteurs 8 à 10.

De préférence, les poignées 6 et 7 sont réalisées d'une seule pièce en matériau plastique rigide. Dans ce cas, il est clair que la protubérance 6B, 7B est introduite dans un trou ménagé à cet effet dans la face avant 4 (non représenté pour simplifier les Figures 4 et 5).

L'ensemble formé par la carte 2 et la face avant 4 est inséré dans la fente F de l'embase 17 de la base 3.

La face avant est une pièce spécifique à chaque type d'adaptateur (y compris l'adaptateur d'interface) puisque les connecteurs 8 à 10 sont spécifiques de chaque liaison de transmission (V-11, V-24, V-28, V-35, etc...).

Le couvercle 11 est muni de parties latérales 18, 19, 22 et 23 qui lui sont perpendiculaires. La partie 18 entre en contact avec la face arrière 5 sans recouvrir l'encoche 16, permettant ainsi le passage du connecteur 14, lors du montage de la cartouche. La partie latérale 22 du couvercle Il est parallèle à la face avant 4 et vient se loger contre celle-ci, à l'intérieur de la cartouche. La partie latérale inférieure 23 est munie de deux ergots G1 et G2 s'insérant dans les encoches E1 et E2 lors du montage de la cartouche. Après cette insertion, le couvercle 11 est verrouillé par une vis 12 passant à travers un trou 15 pratiqué dans la partie supérieure de 11, sur une collerette 13 faisant partie de la carte 2.

La partie latérale 19, ou partie latérale supérieure du couvercle 11, est à la fois perpendiculaire au support de base 3 et aux faces avant 4 et arrière 5.

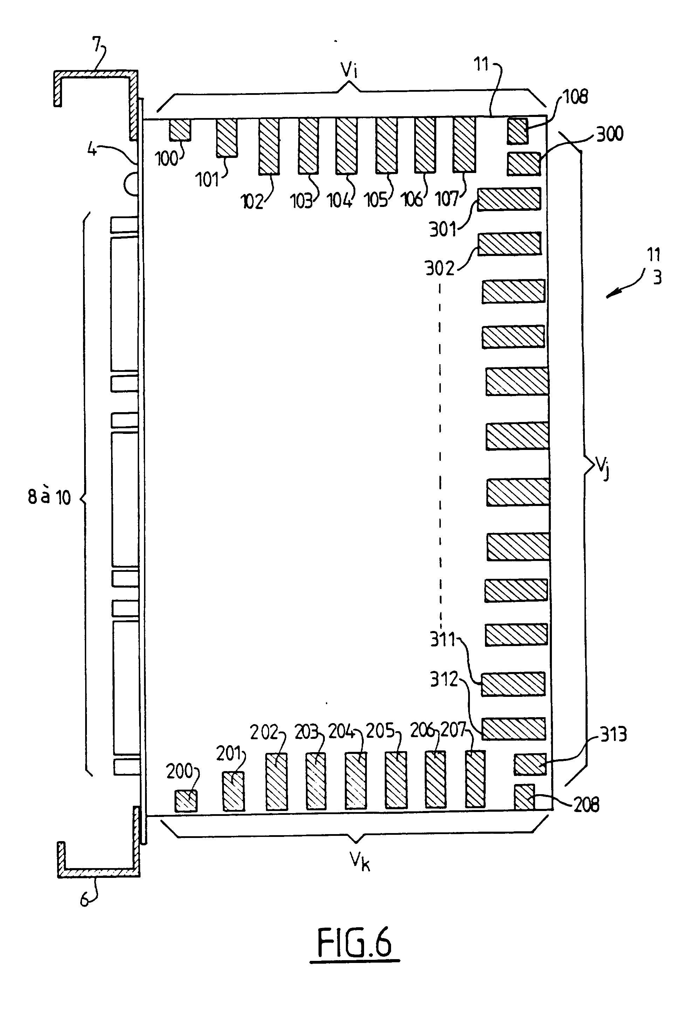

Le couvercle 11, (ainsi que la base 3 de manière identique) présente, ainsi qu'on peut le voir à la Figure 6, une pluralité de trous rectangulaires de ventilation répartis sur sa périphérie, sur les côtés de celle-ci autres que le côté en contact avec la face avant 4. Ainsi, les deux côtés du couvercle 11 perpendiculaires à la face avant 4 (petites dimensions du rectangle que forme le couvercle 11) sont munis chacun respectivement d'un ensemble de trous de ventilation Vᵢ et Vₖ, alors que le grand côté du rectangle que forme le couvercle 11, parallèle à la face avant 4, à la Figure 6, est munie d'un ensemble de trous de ventilation Vⱼ.

L'ensemble de trous de ventilation Vᵢ comprend les trous de ventilation 100 à 108, ces trous étant numérotés dans l'ordre croissant au fur et à mesure que leur éloignement de la face avant 4 est plus grand. Ainsi le trou de ventilation 100 est le plus proche de la face avant 4, alors que le trou 108 en est le plus éloigné. Le trou 100 est celui des trous de ventilation qui a la plus faible surface, et les trous 102 à 107 ont la plus grande surface (cette surface est la même pour tous ceux-ci), les trous 101 et 108 ayant une surface intermédiaire. Il en est de même pour l'ensemble de ventilation Vk qui comporte les trous de ventilation 200 à 208, le trou 200 étant le plus proche de la face avant 4 et le trou 208 le plus éloigné, les trous 202 à 207 ayant la plus grande surface (ayant tous la même surface) identique à celle des trous 102 à 107), les trous 201 et 208 ayant une surface intermédiaire. Ainsi qu'on peut le voir à la Figure 6, tous les trous de ventilation 100 à 108, 200 à 208 ont une forme rectangulaire et leur grande dimension est parallèle à la face avant 4 et à la grande dimension que forme le couvercle 11.

L'ensemble de trous de ventilation Vⱼ comprend les trous de ventilation 300 à 313, le trou de ventilation 300 étant situé dans la partie supérieure de la Figure 6, alors que le trou de ventilation 313 est situé à la partie inférieure. Les deux trous de ventilation 300 et 313 ont une même surface inférieure à celle des trous de ventilation 301 à 312 qui ont tous la même surface. Les trous de ventilation 300 à 313 ont une forme rectangulaire et leur grande dimension est parallèle à celle des petits côtés que forme le couvercle 11, c'est-à-dire perpendiculaire à la face avant 4.

La présence d'un grand nombre de trous de ventilation pratiqués dans le couvercle 11 de la cartouche 1 est nécessaire car la puissance thermique dissipée par l'ensemble des composants formant l'adaptateur porté par la carte 2 est de l'ordre de 12 W. Il est donc nécessaire d'évacuer la chaleur dissipée par ces composants et ce sont donc Vᵢ, Vⱼ, Vₖ qui jouent ce rôle.

L'enveloppe mécanique de la carte 2 de la cartouche 1 a pour fonction :
- une protection mécanique de la carte 2,
- une protection de l'entourage géographique immédiat de la structure d'accueil comprenant la cartouche 1, contre les différents rayonnements hertziens émis par les composants de la carte 2 ,
- une protection de la carte 2 en susceptibilité électromagnétique (protection contre l'ensemble des champs magnétiques de toutes sortes émis par les appareils électriques se trouvant dans l'entourage géographique immédiat de la structure d'accueil comportant la cartouche 1).

On se reporte désormais aux Figures 8 à 10 qui montrent une structure d'accueil P pour une pluralité de cartouches telles que 1.

Dans l'exemple de réalisation préférée de l'invention décrit ici, la structure d'accueil P peut contenir 16 cartouches, à savoir 15 cartouche AD à AD₁₄ contenant des adaptateurs de terminaux et une cartouche ADI contenant un adaptateur d'interface (décrite plus loin). On désigne donc désormais, sous la même référence, l'adaptateur lui-même et la cartouche le contenant. La cartouche AD occupe la partie située la plus à droite de la Figure 8 alors que la cartouche ADI occupe la partie située la plus à gauche de cette même Figure.

La structure P comprend essentiellement trois grandes parties, à savoir :
- un premier compartiment avant CAV qui permet de loger les 16 cartouches AD à AD₁₄ et ADI, formant châssis pour le guidage des cartouches et la fixation du fonds de panier FP..
- un second compartiment arrière CAR qui comporte le dispositif d'alimentation ALIM permettant l'alimentation électrique de l'ensemble des cartouches précitées, ainsi qu'un dispositif de ventilation forcée de la structure P, à savoir VNT,
- un fond de panier FP portant le bus ETHERNET en cuivre BCE, ce fond de panier étant muni de connecteurs permettant la connexion de chacune des cartouches, AD à AD₁₄ et ADI, au bus BCE.

Le fond de panier FP sépare le premier compartiment CAV du second compartiment CAR, lesquels sont considérés comme adjacents l'un à l'autre. Il est perpendiculaire à chacune des cartes 2 que comportent les 15 cartouches AD à AD₁₄.

La structure d'accueil P a la forme d'un parallélépipède rectangle, chacun des premier et second compartiments ayant également une forme de parallélépipède rectangle.

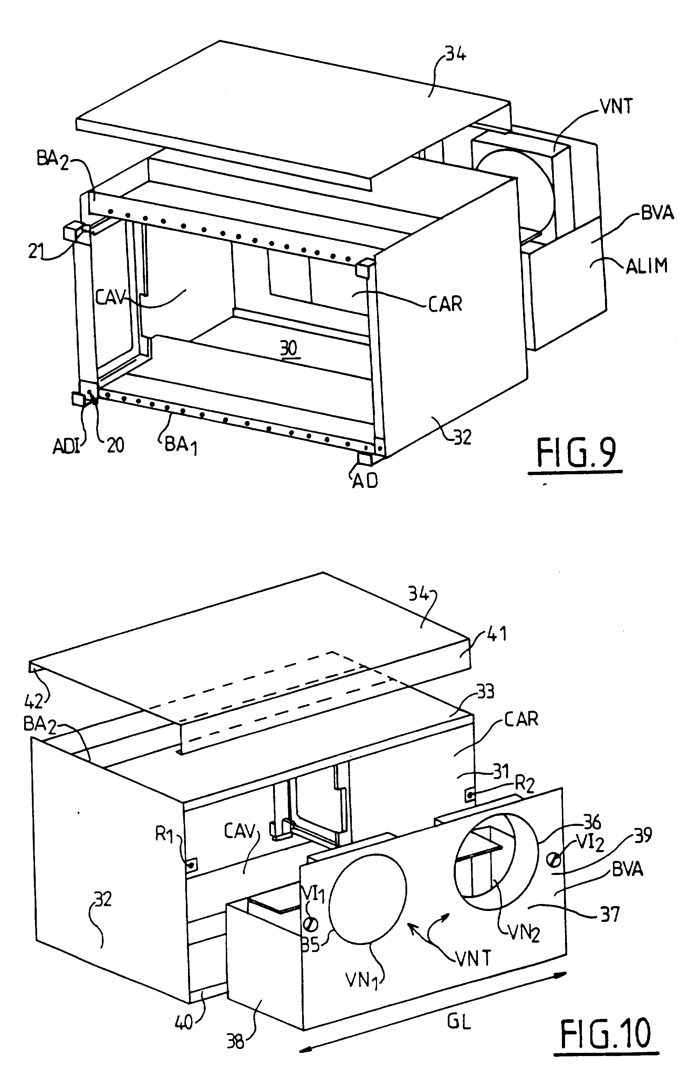

Les cartouches, AD à AD₁₄ et ADI, sont introduites par l'avant 30 de la structure d'accueil P. Les cartouches sont introduites de telle manière qu'elles soient perpendiculaires à cet avant 30 et parallèles les unes aux autres (on assimile les cartouches à des surfaces rectangulaires pour pouvoir dire qu'elles sont parallèles les unes aux autres : cela signifie également que les cartes 2 portant les adaptateurs correspondants sont parallèles les unes aux autres). Une fois insérée dans le compartiment CAV, chacune des cartouches y est verrouillée par l'intermédiaire de ses vis moletées de fixation 20 et 21. Celles-ci viennent se visser à l'intérieur de trous taraudés pratiqués dans deux barres inférieure et supérieure BA₁, BA₂, parallèles entre elles, disposées sur l'avant 30 du compartiment CAV et parallèles à sa grande dimension. Ces trous sont symbolisés par des points alignés sur BA₁ et BA₂ à la Figure 9. Si l'on veut changer l'une des cartouches, par exemple lorsque l'adaptateur correspondant est défectueux, ou pour une opération de maintenance, on peut retirer cette cartouche sans interrompre le fonctionnement des autres et la remplacer par une cartouche similaire.

Aux Figures 9 et 10, on peut voir plus en détail, comment est constitué le compartiment arrière CAR de la structure d'accueil P.

Ce compartiment arrière inclut un bloc BVA de ventilation et d'alimentation qui est introduit, lors du montage de la structure d'accueil P, dans le compartiment arrière, par la face arrière 31 de ce dernier, au moment de sa connexion au fond de panier.

Le bloc BVA comprend une alimentation ALIM et un bloc de ventilation VNT : lorsque BVA est introduit entièrement dans le compartiment CAR, ALIM se connecte directement au fond de panier FP, de manière connue en soi par l'intermédiaire d'un couple de connecteurs DIN 96 points standard et d'un circuit souple interne à ALIM.

La face arrière du bloc BVA, à savoir 37, comporte deux évidements circulaires 35 et 36 à l'intérieur desquels sont montés des ventilateurs VN₁ et VN₂ qui constituent le bloc de ventilation VNT. Les ventilateurs VN₁ et VN₂ sont identiques. Il est clair que lorsque le bloc BVA est monté à l'intérieur du compartiment arrière CAR, sa face arrière 37 est confondue avec la face arrière 31.

La face arrière 31 comporte un rebord 40 de hauteur très faible, très inférieure à la hauteur totale de la structure P, qui est parallèle à la face avant 30 de P. Ce rebord contribue à maintenir en place le bloc BVA lorsque celui-ci est inséré dans le second compartiment arrière CAR. Une fois le bloc BVA introduit dans ce compartiment, il est maintenu en place, d'une part par le rebord 40 et d'autre part au moyen de deux vis VI₁ et VI₂ disposées sur les bords de 37, de part et d'autre respectivement de 35 et 36, et fixées sur des rebords R₁ et R₂ disposés sur 31 et solidaires des côtés 32 et 33 de la structure P. Cette dernière comprend un couvercle 34 perpendiculaire aux faces avant 30 et 31 de la structure d'accueil P.

Le couvercle 34 est inséré par glissement au moyen de ses rebords avant 42 et arrière 41 sur la partie supérieure de la structure P (par exemple au moyen de glissières disposées dans cette partie supérieure, sur les faces avant et arrière 30 et 31, et non représentées pour simplifier les Figures 8 à 10, mais qui sont évidentes pour l'homme de métier). Ce couvercle est verrouillé par la mise en place définitive de BVA lorsque VI₁ et VI₂ sont fixées sur R₁ et R₂, son rebord arrière 41 étant maintenu solidement en place par 37.

On considère les Figures 11a, 11b, 11c qui montrent le fond de panier FP qui porte le bus ETHERNET en cuivre BCE. Ce fond de panier FP comporte une carte de circuit imprimé CI sur laquelle est gravé le bus cuivre. Ce dernier comprend deux branches B₃ et B₅ parallèles entre elles et parallèles à la longueur du fond de panier FP de forme rectangulaire, deux branches B₂ et B₄ parallèles entre elles et parallèles à sa largeur et une branche de raccordement B₁ de faible longueur parallèle aux deux branches principales B₃ et B₅. Les trois branches B₃, B₂ et B₅ forment, ainsi qu'on peut le voir à la Figure 11, un U auquel est relié la branche B₄, elle-même reliée à la branche B₁. De la sorte, les cinq branches B₁ à B₅, qui ne présentent pas de discontinuité électrique, forment le bus BCE. Ce bus cuivre BCE comporte trois pistes de cuivre parallèles, à savoir la piste centrale PC et les deux pistes latérales PL₁ et PL₂. Elles jouent le même rôle que la couche de blindage d'un câble coaxial 50 ohms. Elles ne sont reliées ni à la masse de la structure P, ni au 0 Volt logique de ALIM. Elles sont en contact électrique avec la couche de blindage des câbles coaxiaux du réseau RE extérieurs à P par l'intermédiaire de ADI.

La disposition des pistes, leurs dimensions et leurs positions respectives ont pour objectif le respect de l'impédance nominale caractéristique de 50 ohms spécifique d'un câble coaxial ETHERNET. On réalise ainsi sur le fond de panier FP une liaison de type coaxial alors que les pistes sont en fait gravées sur cuivre. La piste centrale permet le transport des informations depuis le réseau RE vers chacun des adaptateurs AD à AD₁₄.

Le fond de panier FP comprend une pluralité de connecteurs femelles CF, CF₁ à CF₁₄ permettant la connexion, par l'intermédiaire des connecteurs mâles 14, (voir Figures 4 et 5) des adaptateurs AD à AD₁₄ au réseau RE. Les connecteurs sont des connecteurs de type DIN REVERSE 41.612 de 48 points dont six points ne sont pas utilisés comme le montre la Figure 11b qui est une vue plus détaillée de la Figure 11a, montrant notamment les connecteurs CF, CF₇, CF₁₄. Pour chacun des connecteur CF à CF₁₄, on a supprimé 6 points de connexion, à savoir les points 7b, 8b, 9b, 7c, 8c, 9c. On a gardé par contre les points 7a, 8a, 9a permettant de connecter chacun des connecteurs en question à respectivement PL₂, PC et PL₁, au niveau de la branche principale centrale B₃ de BCE.

Par ailleurs, le fond de panier FP comprend un connecteur CORE permettant sa connexion aux câbles coaxiaux extérieurs par l'intermédiaire de ADI (BNC₁, BNC₂). Ce connecteur CORE est un connecteur femelle du type DIN 41612 78 points forme M.

Ainsi qu'il est visible à la Figure 11b, CORE est connecté à la branche B1, par l'intermédiaire de deux points de connexion à PL₁, deux points de connexion à PL₂ et un point de connexion à PC. CORE est connecté à la partie supérieure de B₅ de la même façon. On voit que CORE n'est pas connecté à la branche B₃. On voit également qu'aux extrémités de B₁ et B₅, PL₁ et PL₂ sont reliées ensemble. PL₁ et PL₂ sont électriquement de signe négatif et PC de signe positif, selon la norme ETHERNET.

La Figure 11c montre en coupe perpendiculaire suivant AB la forme des pistes PL₁, PC et PL₂.

La piste PC est de forme rectangulaire reliée à un fil F₁ qui lui est perpendiculaire. Les pistes PL₁ et PL₂ sont symétriques par rapport à F₁. PL₁ comprend deux conducteurs latéraux de forme rectangulaire 51 et 52 entourant un conducteur central 50 de forme également rectangulaire mais de surface inférieure à 51 et 52. 50, 51 et 52 sont reliés à un même fil F₂ qui leur est perpendiculaire.

PL₂ a la même structure que PL₁ et comporte 2 conducteurs latéraux 61, 62 entourant un conducteur central 60, ces trois conducteurs étant reliés à un même fil F₃ qui leur est perpendiculaire.

Le connecteur femelle CORE permet la connexion du fond de panier à l'adaptateur d'interface ADI par l'intermédiaire du connecteur mâle correspondant disposé sur la face arrière de cet adaptateur d'interface. Ce connecteur mâle est disposé de la même manière que le connecteur 14 des Figures 4 et 5. L'adaptateur d'interface ADI est inclus dans une cartouche dont la constitution est analogue à celle de la cartouche 1 montrée aux Figures 4 à 7. Dans ce cas, le connecteur 14 est un connecteur DIN 41612 78 + 2 points forme M, coudé mâle. La cartouche d'interface ADI a une face avant légèrement modifiée par rapport à la face avant 4 des Figures 4, 5, 6 et 7a. Cette même face avant 4 de la cartouche ADI est montrée à la Figure 7b. Elle comporte les mêmes poignées de fixation 6 et 7 que la cartouche 1. Elle comporte deux roues codeuses RC₁, RC₂. Chacune de ces deux roues codeuses permet un codage sur 8 bits de telle sorte que l'ensemble des deux roues codeuses permet un codage hexadécimal (OO à FF) donnant le code de l'adresse géographique de la structure d'accueil P des adaptateurs AD à AD₁₄ (les adaptateurs AD à AD₁₄ correspondent, par exemple, aux adaptateurs AD à ADₘ montrés aux Figures 1 et 2 constituant le système adaptateur SAD avec m = 14, P constituant la structure d'accueil de SAD).

La face avant 4 de ADI comporte en outre deux connecteurs normalisés BNC₁, BNC₂ permettant de relier cet adaptateur d'une part au réseau RE (par exemple par l'intermédiaire de BNC₁) et d'autre part, par l'intermédiaire de BNC₂ à une autre structure d'accueil contenant un autre système adaptateur que SAD.

La carte 2 de ADI ne comporte que des conducteurs de liaison entre BNC₁, BNC₂ et 14.

La description ci-dessus permet donc de mieux comprendre comment les adaptateurs AD à AD₁₄ sont reliés au réseau RE par l'intermédiaire de l'adaptateur d'interface ADI. (En fait, chaque interface IFC est donc reliée à RE par l'intermédiaire de 14, de l'un des connecteurs CF à CF₁₄, de BCE et de ADI).

On considère les Figures 12 et 13.

La Figure 12 montre comment sont reliés entre eux 45 adaptateurs AD à AD₄₄ selon une liaison ETHERNET standard. Chacun des adaptateurs, dans ce cas, est connecté à son voisin par l'intermédiaire d'un coaxial ayant une longueur minimum de 0,50 m. Ainsi, l'adaptateur AD est-il relié à l'adaptateur AD₁ par l'intermédiaire d'une liaison coaxiale LC₁ ayant une longueur minimum de 0,50 m. L'adaptateur est lui-même relié par l'intermédiaire d'un coaxial CX au serveur SERV, des terminateurs ayant une impédance de 50 ohms étant situés aux deux extrémités de la liaison l'un sur le serveur SERV et l'autre sur le dernier adaptateur AD₄₄, ces deux terminateurs étant désignés par T₁ etT₂. De la sorte, la distance maximum entre le serveur et l'adaptateur AD₄₄ est de 280 m maximum (longueur maximum d'une liaison ETHERNET sur câble coaxial 50 ohms, selon la norme).

La Figure 13 montre ce qu'il en est avec une liaison utilisant des structures d'accueil P, P₁, P₂ comprenant chacune 15 adaptateurs, à savoir respectivement les adaptateurs AD à AD₁₄ pour la structure d'accueil P, les adaptateurs AD₁₅ à AD₂₉ pour la structure d'accueil P₁, les adaptateurs AD₃₀ à AD₄₄ pour la structure d'accueil P₂. La structure d'accueil P contient le système adaptateur SAD, alors que les structures d'accueil P₁ et P₂ contiennent les systèmes adaptateurs SAD₁ et SAD₂.

Le serveur SERV, ou un système informatique serveur SISⱼ, est relié par l'intermédiaire d'un coaxial CX ou CX₂ au premier système adaptateur SAD. Le système SAD (la structure d'accueil P) est relié par l'intermédiaire de BNC₂ et du coaxial LC₁ ayant une longueur minimum de 0,50 m au système adaptateur SAD₁ (en BNC₁), lui-même relié par BNC₂ et une liaison coaxiale ayant une longueur minimum de 0,50 m, à savoir LC₂, au système adaptateur SAD₂ en BNC₁.

Ainsi on voit que l'ensemble formé par les trois systèmes adaptateurs SAD, SAD₁, SAD₂ (par les trois structures d'accueil P, P₁, P₂) est beaucoup plus compact, moins encombrant, et beaucoup plus pratique que celui de la Figure 12 dont la longueur minimum est de 220 m. L'ensemble formé par SAD à SAD₂ a donc une longueur minimum de 1 m. Toutefois, la longueur maximum du réseau constitué par le serveur SERV et les 45 adaptateurs AD à AD₄₄ de la Figure 12 a une longueur maximum de 280 m. L'ensemble formé par le serveur SERV et les 3 systèmes adaptateurs SAD à SAD₂ a une longueur maximum de 100 m pour tenir compte des éventuelles desadaptations d'impédances dues aux différents fonds de panier FP de SAD, SAD₁, SAD₂. Toutefois, ce léger inconvénient est plus que largement compensé par les avantages qui ont été indiqués ci-dessus.

## Revendications

1. Structure d'accueil (P)pour adaptateurs de terminaux (AD à AD₁₄, ADI), appartenant à une architecture informatique distribuée (ARCH), formée d'une pluralité de systèmes informatiques (SI, SI₁, SISⱼ, SAD,... SADⱼ) connectés chacun par l'intermédiaire de serveurs de communication (SERV, SERV₁, SERVⱼ₁, SERVⱼ₂) à une pluralité de réseaux (RE, RE₁,... REₖ) de divers types, chaque système étant relié à une pluralité de terminaux synchrones ou asynchrones (T₁, T₂, T₃, Tₘ₁, Tₘ₂, Tₘ₃) par l'intermédiaire d'au moins l'un des réseaux (RE) et d'adaptateurs de terminaux (AD,... ADₘ...ADⱼ) dont chacun est, d'une part connecté audit réseau et d'autre part à au moins un terminal (T₁ à T₃, Tₘ₁ à Tₘ₃, Tⱼ₁ à Tⱼ₃) par l'intermédiaire d'une liaison de transmission synchrone ou asynchrone, caractérisée en ce qu'elle comprend :
- un premier compartiment (CAV) contenant une pluralité de cartouches (1, AD à AD₁₄, ADI) contenant chacune une carte portant le circuit électronique d'un adaptateur,
- un second compartiment (CAR) contenant l'alimentation électrique des cartes contenues dans le premier compartiment et un dispositif de ventilation (VNT) de la structure,
le premier et le second compartiments étant adjacents et séparés par un fond de panier (FP) portant un bus cuivre spécifique (BCE, BCEⱼ) du réseau auquel sont connectées les cartes portant les adaptateurs de terminaux, le fond de panier (FP) comportant des moyens de connexion (CF à CF₁₄, CORE) des cartes au réseau (RE) et au bus (BCE) d'une part et à l'alimentation (ALIM) d'autre part.

2. Structure d'accueil (P) selon la revendication 1 caractérisée en ce que les cartouches (1, AD à AD₁₄, ADI) sont parallèles les unes aux autres et comprennent chacune :
- un support de base (3) de la carte (2) sur lequel celle-ci est fixée,
- une face avant (4) et une face arrière (5) perpendiculaires à la carte (2) et au support (3) comprenant respectivement des premiers moyens de connexion (8 à 10) connectés aux supports de transmission des liaisons des terminaux d'entrée/sortie associés à l'adaptateur porté par la carte, et des seconds moyens de connexion (14) avec le bus spécifiques (BCE, BCEⱼ),
- un couvercle (11) refermant la cartouche parallèle à la carte (2) et au support de base (3).

3. Structure d'accueil (P) selon la revendication 2, caractérisée en ce que la face avant (4) comporte dans sa partie supérieure et dans sa partie inférieure des moyens (7, 6) de préhension et de verrouillage de la cartouche correspondante à l'intérieur du premier compartiment (CAV).

4. Structure d'accueil (P) selon les revendications 2, 3, caractérisée en ce que le couvercle de forme rectangulaire (11) et le support de base (3) portent sur les trois côtés de leur périphérie autres que celui en contact avec la face avant (4), une pluralité d'ensembles (Vᵢ, Vⱼ, Vₖ) de trous de ventilation permettant l'évacuation de l'énergie thermique dégagée par les composants de la carte portant l'adaptateur.

5. Structure d'accueil (P) selon la revendication 4, caractérisée en ce que les trous de ventilation sont de forme rectangulaire, leur longueur étant perpendiculaire auxdits trois côtés, les ensembles de ventilation situés sur les petits côtés étant identiques entre eux.

6. Structure d'accueil (P) selon les revendications 2 à 5, caractérisée en ce qu'elle comprend une cartouche assurant l'interface entre le réseau (RE) et le bus spécifique (BCE, BCEⱼ), comportant sur sa face avant (4) des moyens de connexion (BNC₁, BNC₂) avec le support de transmission du réseau, et sur sa face arrière (5) des moyens de connexion (14) avec ledit bus.

7. Structure d'accueil (P) selon l'une des revendications 1 à 6, caractérisée en ce que le réseau (RE) et le bus spécifique (BCE, BCEⱼ) sont de type ETHERNET, le bus spécifique comportant trois pistes distinctes (PC, PL₁, PL₂), la piste centrale (PC) transportant les informations et étant équidistante des pistes latérales (PL₁, PL₂) qui jouent le rôle d'une couche de blindage de la piste centrale, chacune de ces pistes étant formées par un conducteur gravé dans le cuivre.

8. Structure d'accueil (P) selon la revendication 7, caractérisée en ce que le fond de panier (FP) comprend des troisièmes moyens de connexion (CF à CF₁₄) reliés au bus (BCE) et destinés à être connectés aux seconds moyens de connexion correspondants (14) des faces arrières des adaptateurs, et des quatrièmes moyens de connexion (CORE) destinés à être connectés aux moyens de connexion de la face arrière (14) de la cartouche d'interface (ADI).

## Patentansprüche

1. Aufnahmestruktur (P) für Terminal-Adapter (AD bis AD₁₄, ADI), die zu einem offenen Kommunikationssystem (ARCH) gehören, das aus mehreren Datenverarbeitungssystemen (SI, SI₁, SISⱼ, SAD, ..., SADⱼ) gebildet ist, die jeweils über Kommunikations-Server (SERV, SERV₁, SCRVⱼ₁, SERVⱼ₂) an mehrere Netze (RE, RE₁, ..., REₖ) unterschiedlichen Typs angeschlossen sind, wobei jedes System über wenigstens eines der Netze (RE) und Terminal-Adapter (AD, ..., ADₘ, ..., ADⱼ) , wovon jede einerseits an das Netz und andererseits über eine synchrone oder asynchrone Übertragungsverbindung an wenigstens ein Terminal (T₁ bis T₃, Tₘ₁ bis Tₘ₃, Tⱼ₁ bis Tⱼ₃) angeschlossen ist, mit mehreren synchronen oder asynchronen Terminals (T₁, T₂, T₃, Tₘ₁, Tₘ₂, Tₘ₃) verbunden ist, dadurch gekennzeichnet, daß sie enthält:
- ein erstes Fach (CAV), das mehrere Kassetten (1, AD bis AD₁₄, ADI) enthält, die ihrerseits jeweils eine die elektronische Schaltung eines Adapters tragende Karte enthalten,
- ein zweites Fach (CAR), das die Stromversorgung der im ersten Fach enthaltenen Karten sowie eine Belüftungsvorrichtung (VNT) für die Struktur enthält,
wobei das erste und das zweite Fach nebeneinander liegen und durch einen Verdrahtungsrahmenboden (FP) getrennt sind, der einen für das Netz spezifischen Bus aus Kupfer (BCE, BCEⱼ) trägt, an den die die Terminal-Adapter tragenden Karten angeschlossen sind, wobei der Verdrahtungsrahmenboden Mittel für den Anschluß (CF bis CF₁₄, CORE) der Karten einerseits an das Netz (RE) und den Bus (BCE) und andererseits an die Versorgung (ALIM), enthält.

2. Aufnahmestruktur (P) nach Anspruch 1, dadurch gekennzeichnet, daß die Kassetten (1, AD bis AD₁₄, ADI) zueinander parallel sind und jeweils enthalten:
- einen Basisträger (3) der Karte (2), auf dem diese befestigt ist,
- eine vordere Fläche (4) und eine hintere Fläche (5), die zur Karte (2) und zum Träger (3) senkrecht sind und erste Anschlußmittel (8 bis 10), die an die Übertragungsträger der Verbindungen der Eingabe/Ausgabe-Terminals angeschlossen sind, die zu dem von der Karte getragenen Adapter gehören, bzw. zweite Anschlußmittel (14) für den Anschluß an den spezifischen Bus (BCE, BCEⱼ) enthalten,
- einen zur Karte (2) und zum Basisträger (3) parallelen Deckel (11), der die Kassette verschließt.

3. Aufnahmestruktur (P) nach Anspruch 2, dadurch gekennzeichnet, daß die vordere Fläche (4) in ihrem oberen Teil und in ihrem unteren Teil Mittel (7, 6) zum Greifen und Verriegeln der entsprechenden Kassette innerhalb des ersten Fachs (CAV) enthält.

4. Aufnahmestruktur (P) nach den Ansprüchen 2, 3, dadurch gekennzeichnet, daß der rechtwinklige Deckel (11) und der Basisträger (3) an den drei Seiten ihres Umfangs mit Ausnahme derjenigen, die mit der vorderen Fläche (4) in Kontakt ist, mehrere Gruppen (Vᵢ, Vⱼ, Vₖ) von Belüftungslöchern aufweisen, die die Abführung der Wärmeenergie ermöglichen, die von den Bauelementen der den Adapter tragenden Karte freigesetzt wird.

5. Aufnahmestruktur (P) nach Anspruch 4, dadurch gekennzeichnet, daß die Belüftungslöcher eine rechtwinklige Form besitzen, wobei ihre Längsseite zu den drei Seiten senkrecht ist und die Belüftungsgruppen, die sich an den kurzen Seiten befinden, untereinander gleich sind.

6. Aufnahmestruktur (P) nach den Ansprüchen 2 bis 5, dadurch gekennzeichnet, daß sie eine Kassette enthält, die die Schnittstelle zwischen dem Netz (RE) und dem spezifischen Bus (BCE, BCEⱼ) sicherstellt und an ihrer vorderen Fläche (4) Anschlußmittel (BNC₁, BNC₂) für den Übertragungsträger des Netzes und an ihrer hinteren Fläche (5) Anschlußmittel (14) für den Bus enthält.

7. Aufnahmestruktur (P) nach einem der Ansprüche 1 bis 6, dadurch gekennzeichnet, daß das Netz (RE) und der spezifische Bus (BCE, BCEⱼ) vom Typ ETHERNET sind, wobei der spezifische Bus drei verschiedene Bahnen (PC, PL₁, PL₂) enthält, wobei die mittlere Bahn (PC) die Informationen befördert und von den seitlichen Bahnen (PL₁, PL₂) gleich beabstandet ist, welche ihrerseits die Rolle einer Abschirmungsschicht für die mittlere Bahn spielen, wobei jede dieser Bahnen durch einen aus dem Kupfer geätzten Leiter gebildet ist.

8. Aufnahmestruktur (P) nach Anspruch 7, dadurch gekennzeichnet, daß der Verdrahtungsrahmenboden (FP) dritte Anschlußmittel (CF bis CF₁₄), die mit dem Bus (BCE) verbunden und dazu bestimmt sind, an die entsprechenden zweiten Anschlußmittel (14) der hinteren Flächen der Adapter angeschlossen zu werden, sowie vierte Anschlußmittel (CORE) enthält, die dazu bestimmt sind, an die Anschlußmittel der hinteren Fläche (14) der Schnittstellen-Kassette (ADI) angeschlossen zu werden.

## Claims

1. A shell structure (P) for terminal adapters (AD to AD₁₄, ADI), belonging to a distributed computer architecture (ARCH), formed from a plurality of computer systems (SI, SI₁, SISⱼ, SAD,...SADⱼ) each connected via communication servers (SERV, SERV₁, SERVⱼ₁, SERVⱼ₂) to a plurality of networks (RE, RE₁,...REₖ) of various types, each system being linked to a plurality of synchronous or asynchronous terminals (T₁,T₂,T₃,Tₘ₁,Tₘ₂,Tₘ₃) via at least one of the networks (RE) and of terminal adapters (AD,...ADₘ...ADⱼ) each of which is on the one hand connected to said network and on the other hand to at least one terminal (T₁ to T₃,Tₘ₁ to Tₘ₃,Tⱼ₁ to Tⱼ₃) via a synchronous or asynchronous transmission link, characterised in that it comprises:
- a first compartment (CAV) containing a plurality of cartridges (1, AD to AD₁₄, ADI) each containing a card bearing the electronic circuit of an adapter,
- a second compartment (CAR) containing the electric power supply for the cards contained in the fist compartment and a device (VNT) for ventilating the structure,
the first and second compartments being adjacent and separated by a rack bottom (FP) bearing a copper bus (BCE, BCEⱼ) specific to the network to which the cards bearing the terminal adapters are connected, the rack bottom (FP) comprising means (CF to CF₁₄, CORE) for connecting the cards to the network (RE) and to the bus (BCE) on the one hand and to the power supply (ALIM) on the other hand.

2. A shell structure (P) according to claim 1 characterised in that the cartridges (1, AD to AD₁₄, ADI) are parallel to each other and each comprise:
- a base support (3) for the card on which the latter is fixed,
- a front face (4) and a rear face (5) perpendicular to the card (2) and to the support (3) respectively comprising first connecting means (8 to 10) connected to the transmission supports of the input/output terminal links associated with the adapter borne by the card, and second means for connecting with the specific bus (BCE, BCEⱼ),
- a cover (11) closing the cartridge parallel to the card (2) and to the base support (3).

3. A shell structure (P) according to claim 2, characterised in that the front face (4) comprises in its upper part and in its lower part means (7, 6) for gripping and locking the cartridge corresponding to the inside of the first compartment (CAV).

4. A shell structure (P) according to claims 2, 3, characterised in that the rectangle shaped cover (11) and the base support (3) bear on the three sides of their periphery other than that in contact with the front face (4), a plurality of a assemblies (Vᵢ,Vⱼ,Vₖ) of ventilation holes allowing the evacuation of the thermal energy released by the components of the card bearing the adapter.

5. A shell structure (P) according to claim 4, characterised in that the ventilation holes are rectangle shaped, their length being perpendicular to said three sides, the ventilation assemblies situated on the small sides being identical to each other.

6. A shell structure (P) according to one of claims 2 to 5, characterised in that it comprises a cartridge effecting the interface between the network (RE) and the specific bus (BCE, BCEⱼ), comprising on its front face (4) means (BNC₁, BNC₂) for connecting with the transmission support of the network, and on its rear face (5) means for connecting with said bus.

7. A shell structure (P) according to one of claims 1 to 6, characterised in that the network (RE) and the specific bus (BCE, BCEⱼ) are of ETHERNET type, the specific bus comprising three distinct tracks (PC, PL₁, PL₂), the central track (PC) conveying the data and being equidistant from the lateral tracks (PL₁, PL₂) which play the part of a screening layer of the central track, each of these tracks being formed by a conductor engraved in the copper.

8. A shell structure (P) according to claim 7, characterised in that the rack bottom (FP) comprises third connecting means (CF to CF₁₄) linked to the bus (BCE) and intended to be connected to the second connecting means (14) corresponding to the rear faces of the adapters, and fourth means (CORE) for connecting the rear face (14) of the interface cartridge (ADI).
